# EUROPEAN PATENT SPECIFICATION

(11) **EP 2 624 292 B1**
(45) Date of publication and mention of the grant of the patent: **22.04.2015**
(21) Application number: 13000338.7
(22) Date of filing: 23.01.2013
(51) Int. Cl.: H01L 21/683

(54) **Substrate transport method and substrate transport apparatus**
Substrattransportverfahren und Substrattransportvorrichtung
Procédé de transport de substrat et appareil de transport de substrat

(30) Priority: 06.02.2012 JP 2012023009
(43) Date of publication of application: 07.08.2013
(73) Proprietor: NITTO DENKO CORPORATION, Osaka 567 (JP)
(72) Inventor: Hase, Yukitoshi, Kameyama-shi, Mie-ken, 519-0193 (JP); Yamamoto, Masayuki, Kameyama-shi, Mie-ken, 519-0193 (JP)
(74) Representative: Hauck Patentanwaltspartnerschaft mbB

(56) References cited:
- WO-A1-2012/121046
- US-A1- 2011 236 171

## Description

### BACKGROUND OF THE INVENTION

### 1. Field of the Invention

This invention relates to a method and apparatus for transporting a substrate, such as a semiconductor wafer and an LED (light Emitting Diode). More particularly, this invention is directed to a technique of dividing a substrate by a dicing process into chips, molding non-defective chips selected from the chips with a resin into a substrate having a circular or quadranglar shape, heating the molded substrate in a given process, and thereafter transferring the substrate.

### 2. Description of the Related Art

In recent years, a semiconductor wafer (hereinafter, appropriately referred to as a "wafer") tends to be ground to have a thickness of several tens micrometers with a need for a high-density package. Accordingly, a circuit and a bump formed on a surface of the wafer may be damaged from a back grinding process until a dicing process, resulting in reduced manufacturing efficiency.

The dicing process is performed to the wafer having a circuit already formed thereon prior to a back grinding process, whereby only non-defective bear chips having a circuit already formed thereon are selected. Only the non-defective chips are molded with a resin to be molded again into a substrate shape. Detailed description thereof is as under.

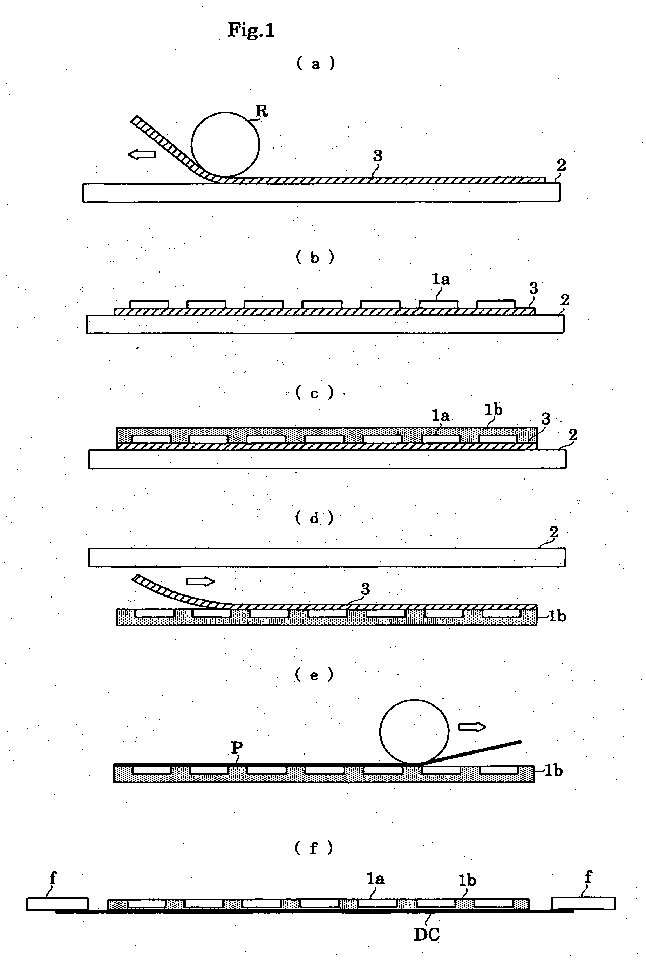

As illustrated in Figure 1(a), an adhesive sheet 3 is pressed with a roller R to be joined to a substrate 2 (e.g., made from aluminum or stainless steel) for support plate. Then, as illustrated in Figure 1(b), the non-defective bear chips 1a are fixedly arranged in a two-dimensional array on the adhesive sheet 3 on the substrate 2 with electrode surfaces of the chip being directed downward. Then, as illustrated in Figure 1(c), the bear chips 1a are molded with a resin 1b to be molded again into a wafer shape. As illustrated in Figure 1(d), an adhesive force in the adhesive sheet 3 is decreased to separate the molded wafer 1 from the substrate 2. At this time, the adhesive sheet 3 remains on a substrate 2 side. Subsequently, as illustrated in Figure 1(e), a protective sheet P is joined on the resin 1b on an electrode-surface side where electrodes are exposed therefrom, and is subjected to back grinding is performed in a direction opposite to the electrode surface. Subsequently, as illustrated in Figure 1(f), the protective tape P is separated after the back grinding to obtain a thinned molded wafer 1. The thinned molded wafer 1 is adhesively held on a ring frame f via a support adhesive tape DC, and is transported to a dicing process where the bear chips are diced. See Japanese Patent Publication No. 2001-308116.

In addition, the wafer obtained as above by molding again the non-defective bear chips is transported in a non-contact manner under temperature control. Such has been developed and implemented. See Japanese Patent Publication No. 2011-1511449.

Moreover, for reinforcing decreased rigidity of the wafer due to thinner wafer in recent years, a support plate having the same shape as the wafer is joined to the wafer via a double-faced adhesive tape. The support plate is separated during a mount process. In the method of separating the support plates, a double-faced adhesive tape is used. The double-faced adhesive tape has a heat separation property that reduces or loses adhesion due to foaming and expansion from heating, or includes a pressure-sensitive adhesive layer of ultraviolet curable type. The method of separating the double-faced adhesive tape is conducted by heating the wafer with the support plates prior to the mounting process. See Japanese Patent Publication No. 2005-1116679A.

Moreover, the molded wafer W tends to be further upsized with requirements for high density packing in recent years. Consequently, when the wafer is transported while floating on a transport path in a non-contact manner, since the substrate had its own weight larger than hardness of the resin in an uncured condition, the substrate becomes warped. Such problem may arise.

Moreover, the resin already cured is softened again when heated in a subsequent process. Consequently, similarly to the uncured resin, the molded wafer with the softened resin may become warped when transported in a non-contact manner.

Regardless of whether the resin is softened or not cured, the molded wafer becomes warped, and a resin on the outer periphery of the wafer slightly runs toward a rear face of the wafer due to its own weight. The running resin causes a non-uniform thickness of the wafer. Consequently, the wafer cannot be diced accurately along a desired scrub line in the subsequent dicing process. Such problem may arise.

Moreover, when air is sprayed on the cured resin, a surface of the resin may become waved to generate unevenness on the surface.

Moreover, the wafer is also molded in a square shape other than a conventional circular shape. When the molded wafer is transported in a conventional non-contact manner, the wafer can readily rotate about a vertical axis thereof and thus has difficulty in being transported while a given course is maintained. Consequently, a periphery of the molded wafer contacts to side walls for drop prevention that are provided on both ends of a transport course, resulting in damages on the wafer. Such problem may arise.

Document US 2011/0236171 A1 discloses to transport a wafer and an inserting paper with a robot having a holding arm adapted for suction-holding the wafer as well as for spraying compressed air onto the inserting paper in order to generate a region of steady negative pressure.

JP 2011-511449 A discloses methods and device for thermally processing mould wafers. The known device has a loading table held at a constant temperature T2 of 180° and an unloading table held at a constant temperature T4 of 20°. While the wafer is transported from the loading table to the unloading table in a non-contact manner, the wafer is heated at a temperature of 180° with airflow from an air cushion conveyor machine to a rear face of the wafer.

### SUMMARY OF THE INVENTION

Additional features of the invention will be set forth in the description which follows, and in part will be apparent from the description, or may be learned by practice of the invention.

This invention has been made regarding the state of the art noted above, and its primary object is to provide a method and apparatus for transporting a wafer that allows efficient cooling with no damage thereon.

One example of this invention discloses a method of transporting a substrate according to claim 1.

According to the method mentioned above, the substrate in a heated condition is suction-held with the suction plate. Consequently, warp due to its own weight of the substrate can be avoided in the substrate, the own weight of the substrate being larger than hardness of the resin easily bent at a glass transition temperature or more or even less. That is, the substrate is suction-held with the suction plate to be planar forcibly. In addition, the substrate is cooled while contacting to the suction plate. Consequently, the resin can be cured efficiently until having hardness larger than the own weight where warp occurs. As a result, the substrate can be transported to each processing section with no running of the resin, no warp of the substrate and no unevenness on the rear face of the substrate so as to be planar.

Moreover, the substrate is covered with the suction plate. Thus the substrate is ensured to be transported to a target position along a given transport path with a constant attitude of the substrate. Consequently, the substrate can be prevented from contacting to the other structures to be damaged during a transport process.

The method mentioned above is preferably conducted as under. For instance, in a process of transporting the substrate while suction-holding it with the suction plate on two or more tables including a loading table and an unloading table with various set temperatures, a cooling temperature of the suction plate is adjusted so as to fall between a set temperature of the loading table and that of the unloading table.

The method allows the resin having the high temperature at start of transportation to be gradually cooled until the wafer is transported onto each table. As a result, warp of the wafer can be eliminated, the warp occurring due to difference in shrinkage between the resin and the chip. Moreover, damages in the wafer due to the warp can also be eliminated.

Moreover, it is preferable that, during transporting the substrate in a heated condition from the loading table while being suction-held with the suction plate, the substrate is cooled into a temperature where the resin does not deform or run due to its own weight, the substrate reaching the temperature is received on the unloading table, and then is cooled on the loading table into room temperatures.

The method allows the resin to be cooled while the substrate is suction-held with the suction table. As a result, warp of the substrate due to its own weight or deformation and running of the resin is ensured to be avoided.

Another example of this invention discloses an apparatus for transporting a substrate according to claim 4.

The configuration above enables the substrate to be transported onto the tables while the substrate is cooled and suction-held with the suction plate. Accordingly, the foregoing method may suitably be conducted.

It is preferable that the configuration above includes a detector for detecting a temperature of the substrate, and that the controller adjusts timing of unloading and loading the substrate from and to each of the tables in accordance with detection data from the detector.

The configuration enables to determine that the resin reaches hardness larger than warp due to its own weight of the substrate. Consequently, the substrate is ensured to be prevented from warping.

Moreover, the configuration above preferably includes a support plate having support claws for supporting the substrate at two or more portions on an outer periphery in a rear face of the substrate that is covered with the resin, and a drive mechanism for moving the substrate on the support claws onto a placing surface of the table and an unloading position above the table by moving the support plate upward and downward.

The configuration enables the substrate to be supported by the support claws at the outer periphery of the rear face thereof upon pacing the substrate on the tables and transporting the substrate from the table. Consequently, running of the resin may be suppressed that likely occurs at the outer periphery of the substrate. In addition, a course of the transport mechanism entering into a direction toward the rear face of the substrate is not blocked.

Moreover, it is preferable that the table in the configuration above includes two or more support pins for supporting the substrate covered with the resin on a center region in a rear face of the substrate.

According to the configuration above, when suction-holding of the substrate with the suction plate is released upon transporting the substrate onto the table, the pins support the center region, resulting in suppression of warp in the substrate. In addition, the support claws support the outer periphery of the substrate and the pins support the middle portions of the substrate, whereby the substrate can be supported planarly. Consequently, it becomes possible to maintain the substrate planarly upon loading and unloading the substrate.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.
Figure 1 is an explanatory view illustrating a manufacturing process of a molded wafer according to the prior art.
Figure 2 is a plan view illustrating a whole configuration of an apparatus according to one example.
Figure 3 is a side view of a workpiece having a support plate joined to the molded wafer.
Figure 4 is a sectional view of the molded wafer,
Figure 5 is a schematic overall perspective view of a third substrate transport apparatus.
Figure 6 is a plan view of the third substrate transport apparatus.
Figure 7 is a longitudinal sectional view of the third substrate transport apparatus.
Figure 8 is a block diagram of the third substrate transport apparatus.
Figure 9 is a side view of a support-plate removing mechanism.
Figure 10 is a plan view of the surrounding of a first table.
Figure 11 is a front view of the surrounding of the first table.
Figure 12 is a perspective view of a separation roller.
Figures 13 to 16 are explanatory views each illustrating operation of separating a double-faced adhesive tape.
Figures 17 to 21 are explanatory views each illustrating operation of the third substrate transport apparatus.

### DESCRIPTION OF THE PREFERRED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.

Hereinafter, description will be given of an embodiment of the present invention with reference to the drawings.

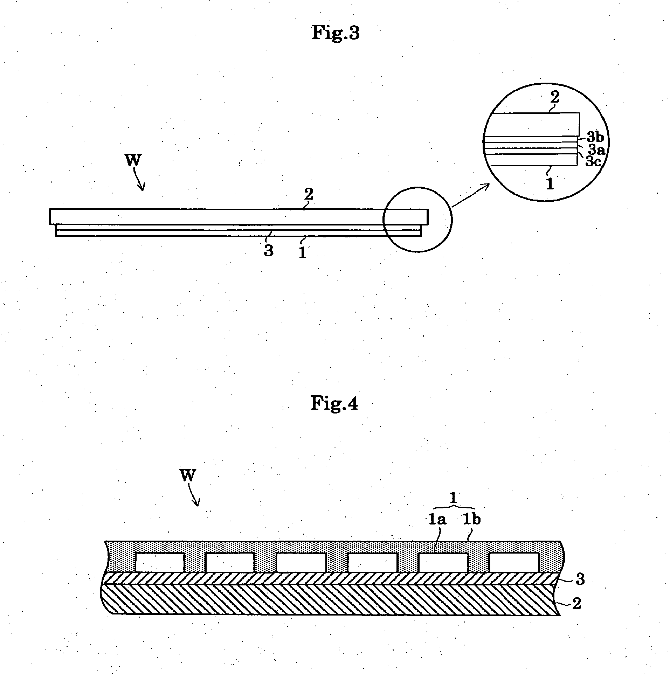

A substrate transport apparatus in one example of this invention is provided in a support-plate separating device. The support-substrate separating device separates a wafer 1 prior to back grinding from a support plate 2, the wafer 1 being joined coaxially to the support plate 2 via a double-faced adhesive tape 3, as illustrated in Figure 3. The support plate 2 is formed of a stainless steel, a glass substrate, or a silicon substrate. Here, the support plate 2 has a size equal or larger than the wafer 1.

Here, the wafer 1 is formed as follows. That is, bear chips 1a in Figure 4 to which a dicing process is performed are inspected after circuit formation on a wafer surface for sorting out only non-defective bear chips 1a. The non-defective bear chips 1a are fixedly arranged in a two-dimensional array on the double-faced adhesive tape 3 joined to the support plate 2 with electrode surfaces of the chips being directed downward. Moreover, the bear chips 1a are covered with a resin 1b to be molded into a wafer shape.

Now referring again to Figure 3, the double-faced adhesive tape 3 includes a tape base material 3a having adhesive layers 3b and 3c on opposite surfaces thereof.

The adhesive layer 3b with a heat separation property loses its adhesion due to foaming and expansion through heating. The adhesive layer 3c is ultraviolet curable type that reduces its adhesion due to curing by irradiation with ultraviolet rays, or a non-ultraviolet curable type and pressure-sensitive. That is, the support plate 2 is joined to the adhesive layer 3b, whereas the wafer 1 is joined to the adhesive layer 3c.

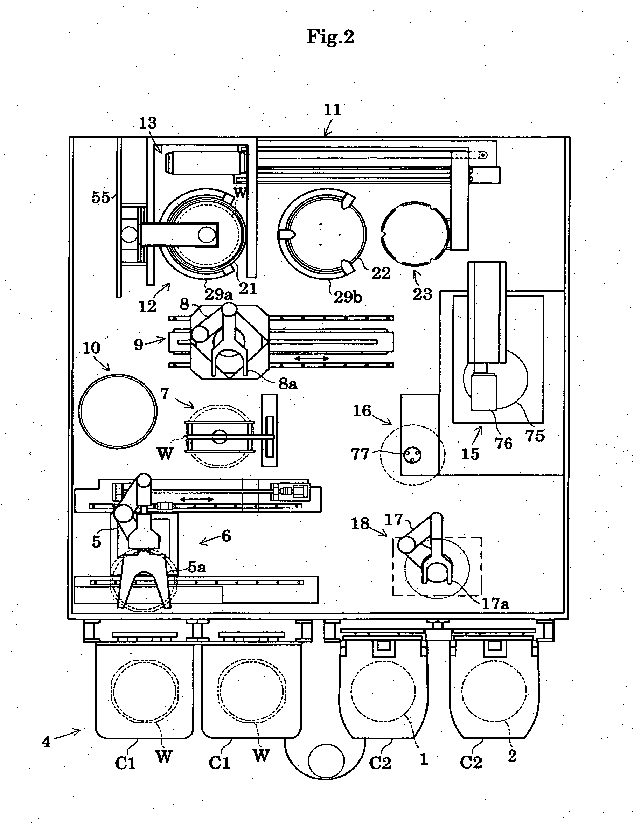

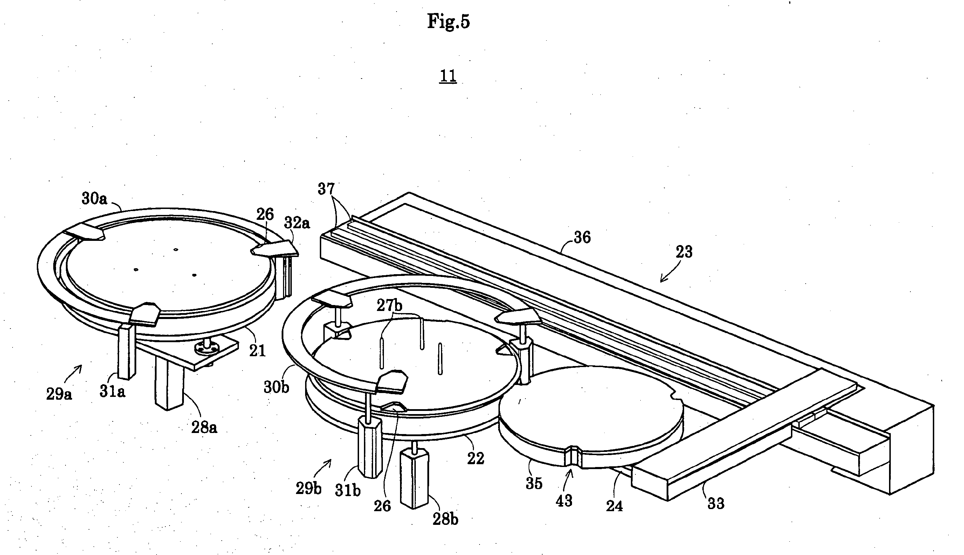

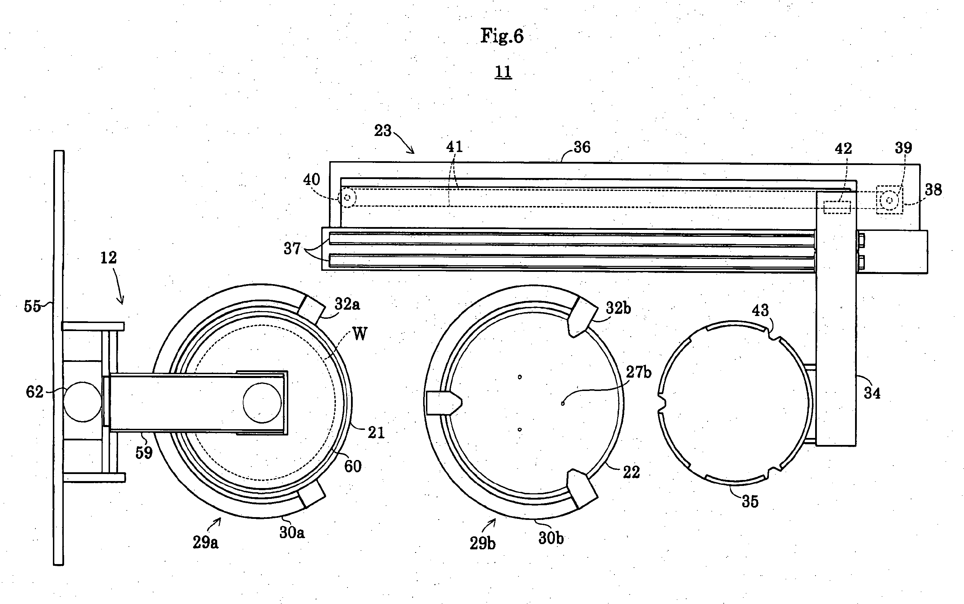

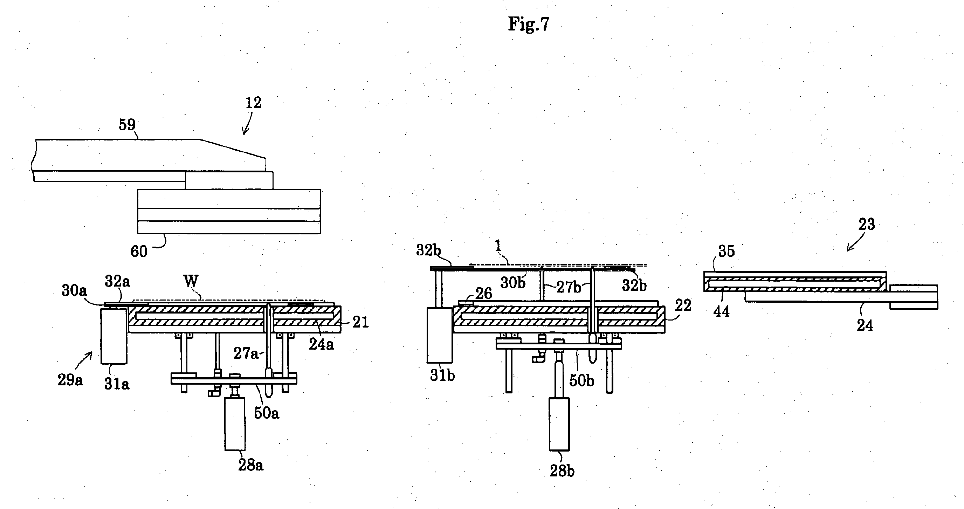

Figure 2 is a plan view of a support plate separating device according to one example of this invention. Figure 5 is a schematic overall perspective view of a third substrate transport apparatus. Figure 6 is a plan view of the third substrate transport apparatus. Figure 7 is a longitudinal sectional view partially illustrating the third substrate transport apparatus.

The support-plate removing device includes a wafer supply/collecting section 4, a first substrate transporting mechanism 6, a cooling mechanism 7, a second substrate transporting mechanism 9, a preheating table 10, a third substrate transporting mechanism 11, a support-plate removing mechanism 12, a tape removing mechanism 13, a tape collecting section 14, a marking section 15, a wafer delivering section 16, and a fourth substrate transporting mechanism 18.

The wafer supply/collecting section 4 has cassettes C1 and cassettes C2 mounted thereon. The cassette C1 houses workpieces W. The cassette C2 houses the wafers 1 and the support plates 2.

The first wafer transporting mechanism 6 has a first robot arm 5. The second wafer transporting mechanism 9 has a second robot arm 8.

The support-plate removing mechanism 12 removes the support plate 2 from the workpiece W.

The tape separating mechanism 12 separates the double-faced adhesive tape 3 from the wafer 1 from which the support plate 2 has been removed.

The tape collecting section 14 collects the removed double-faced adhesive tapes 3.

The marking section 14 marks the wafer 1.

The fourth wafer transporting mechanism 18 has a fourth robot arm 17.

Next, each mechanism will be described in detail.

The wafer supply/collecting section 4 has two cassettes C1 on a supply side and two cassettes C2 on a collection side that are arranged in parallel. The cassettes C1 each house the workpieces W inserted thereinto horizontally in a stack manner with the wafer 1 and the support plate 2 joined together, where the support plate 2 is directed downward. One cassette C2 houses the wafers 1 inserted thereinto horizontally in a stack manner. The support plate 2 is each removed from the wafer 1 and the wafer 1 each have a circuit surface of the bear chips 1a directed upward. The other cassette C2 houses the removed support plates 2 inserted thereinto horizontally in a stack manner.

The first robot arm 5 of the first substrate transporting mechanism 6 is reversible, and movable horizontally. Further, the first robot arm 5 is turnable and movable vertically as a whole. The first robot arm 5 has a tip end provided with a U-shaped workpiece holder 5a of a vacuum-suction type. Moreover, the workpiece holder 5a includes an alignment mechanism. For instance, the workpiece holder 5a has holders at two portions on a tip-end side thereof. The holders are directed upward. The workpiece holder 5a also has two movable pins at corners on a proximal end thereof. When the movable pins are moved, they sandwiches the workpiece W together with the holder for aligning and holding the workpiece W.

The cooling mechanism 7 is formed by a suction pad and a cooling unit. The suction pad sucks the support plate 2 in a heated condition at a center region thereof for rotating the support plate 2. The cooling mechanism 7 includes a cooling unit disposed above the suction pad for spraying air on the rotating support plate 2.

The second robot arm 8 of the second substrate transporting mechanism 9 is movable horizontally. Further, the robot arm 8 is turnable and movable vertically as a whole. The second robot arm 8 has a tip end provided with a U-shaped workpiece holder 8a of vacuum-suction type.

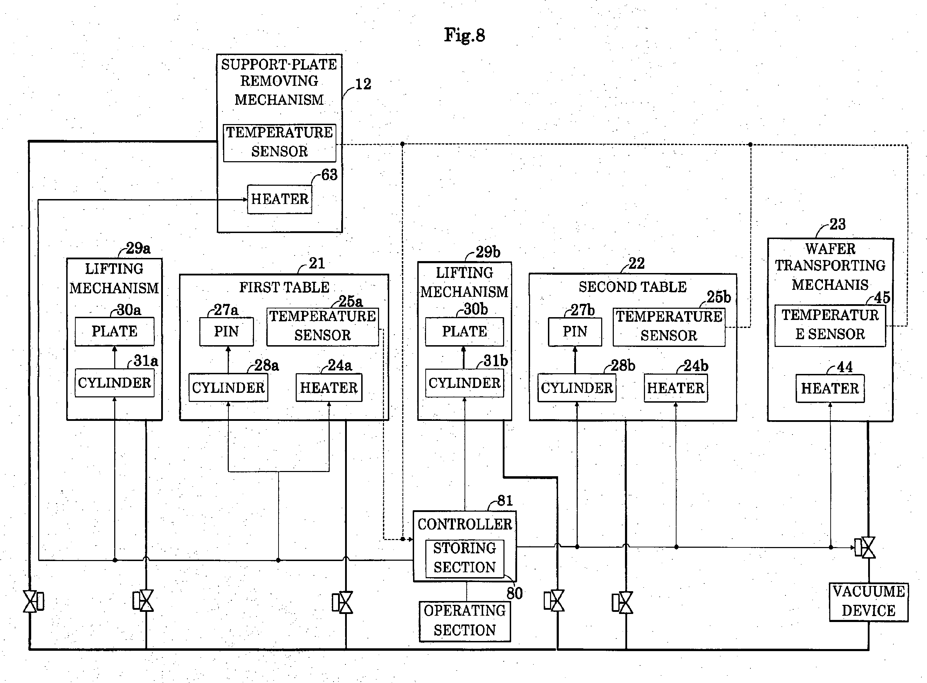

The preheating table 10 is a chuck table having a larger size than the workpiece W and having suction grooves with a minute width (e.g., 1 mm or less) being formed on a front face thereof. The preheating table 10 is made from a heat-insulating material. The preheating table 10 includes inside thereof a heater and a temperature sensor. The temperature sensor detects temperatures on a surface of the workpiece W. Detection signals of the temperature sensor are transmitted to a controller 80 illustrated in Figure 8. Moreover, the preheating table 10 further includes two or more support pins for moving the workpiece upward and downward such that a surface of the workpiece protrudes and retracts.
Moreover, the tip of the support pin is formed of an insulator, or is covered with an insulator.

As shown in Figures 5 and 8, the third substrate transporting mechanism 11 includes a first table 21, a second table 22, and a wafer-transporting mechanism 23. Here, the third substrate transporting mechanism 11 corresponds to the substrate transport apparatus in this invention.

The first table 21 is a chuck table having a larger size than the workpiece W and having suction grooves with a minute width (e.g., 1 mm or less) being formed on a front face thereof. The first table 21 is formed of a heat-insulating material, and includes inside thereof a heater 24a and a temperature sensor 25a (see Figure 8). The temperature sensor 25a detects temperatures on a surface of the workpiece W, and transmits detection signals to the controller 80

The first table 21 has recesses 26 at two or more portions on the outer periphery of thereof. The recess is tapered toward the center thereof. The first table 21 is in communication with an external vacuum device via a channel. The first table 21 also has two or more support pins 27a.

The two or more support pins 27a are spaced at regular intervals on a given circumference of the first table 21. That is, these pins 27a are provided on a movable table 50a. Specifically, the pin 27a is movable upward and downward from a holding surface of the first table 21 via a cylinder 28a coupled to the movable table 50a. Moreover, the tip of the support pin 27a is formed of an insulator, or is covered with an insulator.

A lifting mechanism 29a is placed on the outer periphery of the first table 21. The lifting mechanism 29a receives the workpiece W above the first table 21 and delivers the workpiece W on the first table 21.

The lifting mechanism 29a includes a C-shaped plate 30a having the same curvature as that of the first table 21. The plate 30a moves upward and downward via a cylinder 31a. The plate 30a has two or more support claws 32a arranged thereon. Here, the plate 30a corresponds to the support plate in this invention. The cylinder 31a corresponds to the drive mechanism in this invention.

The tip of the support claw 32a is tapered toward the center of the first table 21. That is, when the plate 30a moves upward and downward, the support claw 32a is housed in the recess 26 provided on the outer periphery of the first table 21. At this time, a surface of the support claw 32a is in the same level as that of the first table 21 or lower than the first table 21. In this example, although three support claws 32a are used, the number is not limited to this. For instance, three or more support claws may be used.

A second table 22 has generally the same configuration as the first table 21. Consequently, a letter of the alphabet "b" is merely given to the number of the same element.

A wafer transporting mechanism 23 is formed by a movable table 33 that moves horizontally, an arm 34 extending from the movable table 33, and a suction plate 35 on a tip end of the arm.

The movable table 33 moves horizontally along two guide rails 37 arranged in parallel on an apparatus base. As shown in Figures 5 and 6, a driving pulley 39 is pivotally supported on a first-end side of the guide rail 37 and is driven by a motor 38 so as to rotate forward/backward. Moreover, an idling pulley 40 is pivotally supported on a second-end side of the guide rail 37. Further, a belt 41 is wound between the driving pulley 39 and the idling pulley 40. A slide engagement part 42 of the movable table 33 is coupled to the belt 41. Thus, when the belt 41 rotates forward/backward, the movable table 33 moves horizontally.

The suction plate 35 is formed of a heat-insulating material having a larger size than the wafer 1 and having suction grooves with a minute width (e.g., 1 mm or less) being formed on a front face thereof. In this example, the suction plate 35 has a diameter smaller than that of the first and second tables 21 and 22. The suction plate 35 includes notches 43 on two or more portions on the outer periphery thereof. The notches are tapered toward the center of the suction plate 35. The notches 43 reach the wafer 1. The suction grooves of the suction plate 35 are in communication with an external vacuum device via two or more channels. The suction plate 35 also includes a heater 44 and a temperature sensor 45. The temperature sensor 45 detects temperatures on the holding surface of the wafer 1, and transmits detection signals to the controller 80.

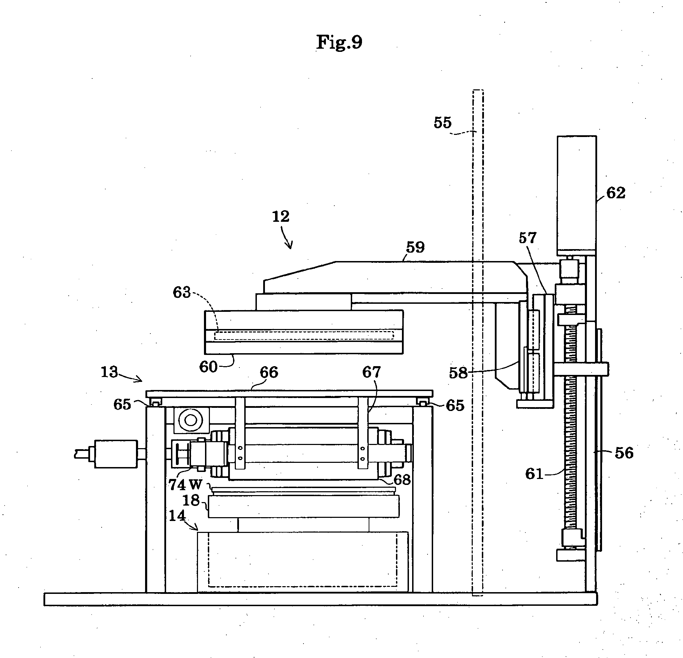

As illustrated in Figure 9, the support-plate removing mechanism 12 includes an upright wall 55, a movable table 57, a movable frame 58, and a suction plate 60.

The movable table 57 can move upward and downward along a rail 56 provided behind the upright wall 55 in a vertical direction. The movable table 57 moves upward and downward in a screw-feed manner by backward and forward rotation of a screw shaft 61 by a motor 62.

The movable frame 58 is attached to the movable table 57 so as to be adjustable in level.

The suction plate 60 is attached to a tip of an arm 59 that extends forward from the movable frame 58. Moreover, a bottom of the suction plate 60 is formed as a vacuum-suction face. Moreover, the suction plate incorporates a heater 63.

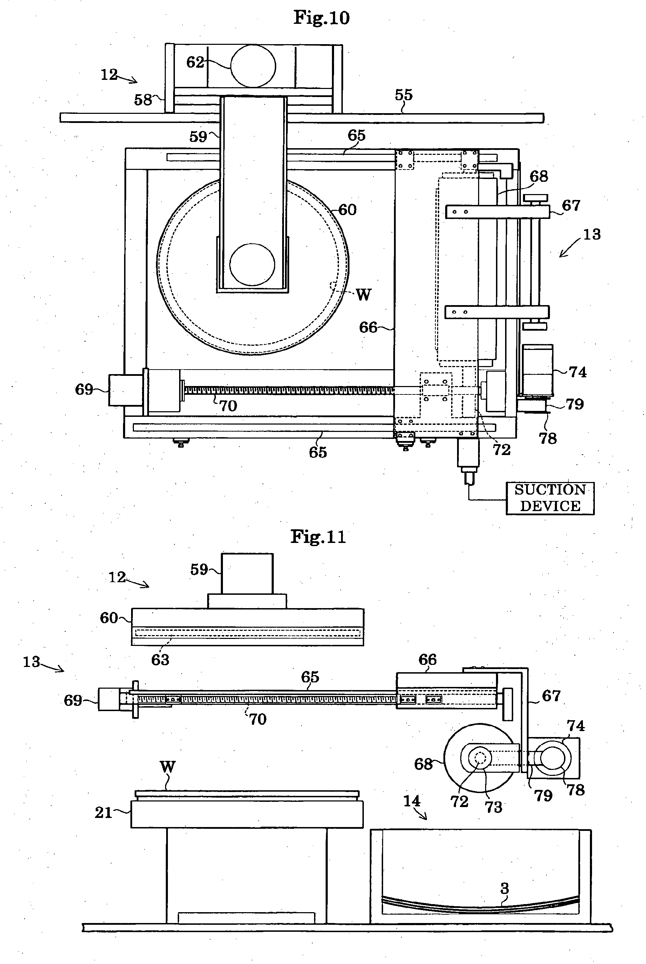

As illustrated in Figures 10 to 12, the tape separating mechanism 13 includes a movable table 66 and a separation roller 68.

The movable table 66 can slide forward/backward along a rail 65. The movable table 66 independently moves in a screw-feed manner through a screw shaft 70 that rotates backward/forward with a motor 69.

The separation roller 68 is attached to a support frame 67 that extends downward from the movable table 66.

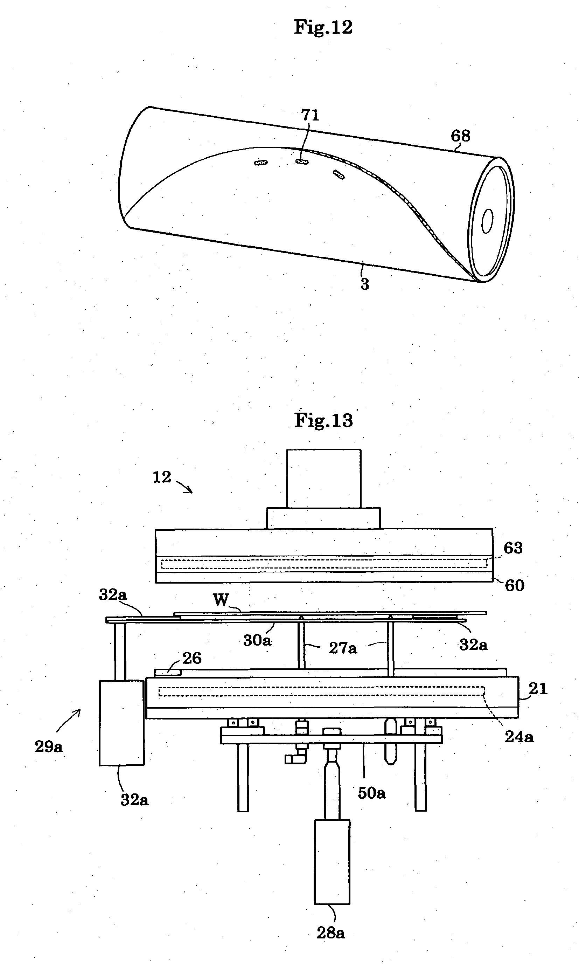

The separation roller 68 can rotate on its axis. As illustrated in Figures 10 and 11, an endless belt 79 is suspended between a pulley 73 attached to a hollow rotation shaft 72 and a driving pulley 78 attached to a driving shaft of a motor 74. Moreover, as illustrated in Figure 12, the separation roller 68 is provided with suction holes 71 on a surface thereof. The separation roller 68 is communicated with an external suction device. Here, the separation roller 68 is covered with an elastic body.

The suction holes 71 are formed at positions corresponding to a separation-start end and a separation-termination end of the double-faced adhesive tape 3. Two or more holes are formed as the suction holes 71 on the separation-start end along an arc of the outer periphery of the tape 3. One long hole is formed as the suction hole 71 on the separation-termination end. The shape and number of the suction hole 71 may vary depending on size and shape of the double-faced adhesive tape 3.

As illustrated in Figure 11, the tape collecting section 14 is provided below the separation roller 68 as a collection box.

Referring again to Figure 2, the marking section 15 includes a chuck table 75 and a laser device 76.

The chuck table 75 suction-holds the wafer 1. The laser device 76 performs marking, such as a two-dimension code and a three-dimensional solid code, to the wafer 1 suction-held with the chuck table 75.

The wafer delivery section 16 includes a suction pad 77 for suction-holding a rear face of the wafer 1 and the support plate 2. The suction pad 77 slidingly moves from a marking section 15 side toward a delivery position to a fourth robot arm 17, and moves upward and downward.

The fourth robot arm 17 of the fourth substrate transporting mechanism 18 is movable horizontally. Further, the fourth robot arm 17 is turnable and movable vertically as a whole. The fourth robot arm 17 has a tip provided with a U-shaped workpiece holder 17a of vacuum suction type.

Next, description will be given of a series of operation of the support-plate removing device with the wafer transporting device with reference to Figures 13 to 21.

First, an operation section illustrated in Figure 8 operates for various settings. For instance, setting is made as for various conditions such as a heating temperature of the heater in the preheating table 10, a heating temperature of the heater 63 in the support-plate removing mechanism 12, and a heating temperature and time of each heater embedded in the first table 21, the second table 22, and the suction plate 35.

The heating temperature of the preheating table 10 is determined as follows, for example. When the wafer 1 and the support plate 2 are joined to the double-faced adhesive tape 3, at least either the double-faced adhesive tape 3 or the resin 1b expands due to pressures from a joining member. In other words, upon completion joining, restoring force is accumulated in the resin 1b and/or the double-faced adhesive tape 3. Consequently, the restoring force may cause slight warp in the workpiece W formed by joining the wafer 1 and the support plate 2 together. Then, warp of the workpiece W is corrected. Specifically, a temperature at which at least either the resin 1 b or the double-faced adhesive tape 3 is softened moderately is set such that the workpiece W may become flat. Since the temperature and time vary in accordance with properties of the resin 1b and the double-faced adhesive tape 3 to be used, they are determined through experiments, simulations in advance.

The heating temperature in the support plate separating mechanism 12 is set in accordance with the double-faced adhesive tape 3 having the adhesion layer 3b with a heat separation property. That is, a temperature is set at which the double-faced adhesive tape 3 foams and expands due to heating and reduces or eliminates its adhesion.

In this example, for example, heating temperatures of the first table 21, the second table 22, and the suction plate 35 are set to become lower in order of the first table 21, suction plate 35, and the second table 22. Setting of the heating temperature is not restricted to this order, but may be modified properly in accordance with properties of the resin to be used and shapes or weights of the wafer 1.

First, the heating temperature of the first table 21 is set at a temperature at which the adhesive layer 3b of the double-faced adhesive tape 3 foams and expands together with the support-plate removing mechanism 12.

The heating temperature of the second table 22 is set such that the temperature of the wafer 1 is approximately room temperatures.

The heating temperature and time for the suction plate 35 are set more strictly than those of the second table 22. Specifically, when the suction plate 35 contacts the resin 1b softened on the first table 21 to cool the resin directly, the heating temperature and time are set as temperatures and times at which conditions are satisfied. In the condition, for example, the softened resin 1b does not run or deform due to its own weight at an edge side of the wafer 1. Since the condition varies in accordance with the resin 1b to be used, it is determined through experiments, simulations in advance. For instance, examples of the condition include a temperature close to the glass transition temperature of the resin 1b or a range containing the glass transition temperature.

The various setting conditions are stored in a storing section 81 provided in the controller 80.

Upon completion of setting for the various conditions, the apparatus operates. Firstly, the first robot arm 5 in the first substrate transporting mechanism 6 moves toward the cassette C1. The workpiece holder 5a at the tip end of the first robot arm 5 is inserted between the workpiece W housed in the cassette C1. The workpiece holder 5a suction-holds the rear face of the wafer W and transports the wafer W. That is, the support plate 2 is held and unloaded. Alignment is also performed in the transporting process. Then, the workpiece holder 5a reverses the workpiece W upside down to direct the resin 1b of the wafer 1 downward. Then the workpiece holder 5a moves the workpiece W to place it on the preheating table 10.

At this time, the pins project over the holding surface of the first table, whereby the preheating table 10 receives the workpiece W, and moves downward. The workpiece W is suction-held on the preheating table 10, and thereafter is heated to a given temperature. The temperature of the workpiece W is detected by a temperature sensor during preheating treatment. When the workpiece W reaches the given temperature, the workpiece W is moved upward by the pins. At this time, the resin 1b or the double-faced adhesive tape 3 is softened slightly, and restoring force in the resin 1b or the double-faced adhesive tape 3 is released. Consequently, slight warp in the workpiece W is eliminated to be planar.

The workpiece W on the preheating table 10 is suction-held with the second robot arm 8 from a front face side, and the workpiece W is transported onto the first table 21. That is, the second robot arm 8 suction-holds the support plate 2.

As illustrated in Figure 13, the workpiece W transported on the first table 21 is supported at the middle region thereof by the pins 27a projected over the table, and is supported at two or more portions on the outer periphery thereof by the support claws 32a in a standby state above the outer periphery of the first table 21. The pins 27a and the support claws 32a move downward synchronously at the same velocity. Consequently, the workpiece W is suction-held on the first table 21 while the resin 1b is directed downward. At this time, the first table 21 is heated into a given temperature in advance with the heater 24a.

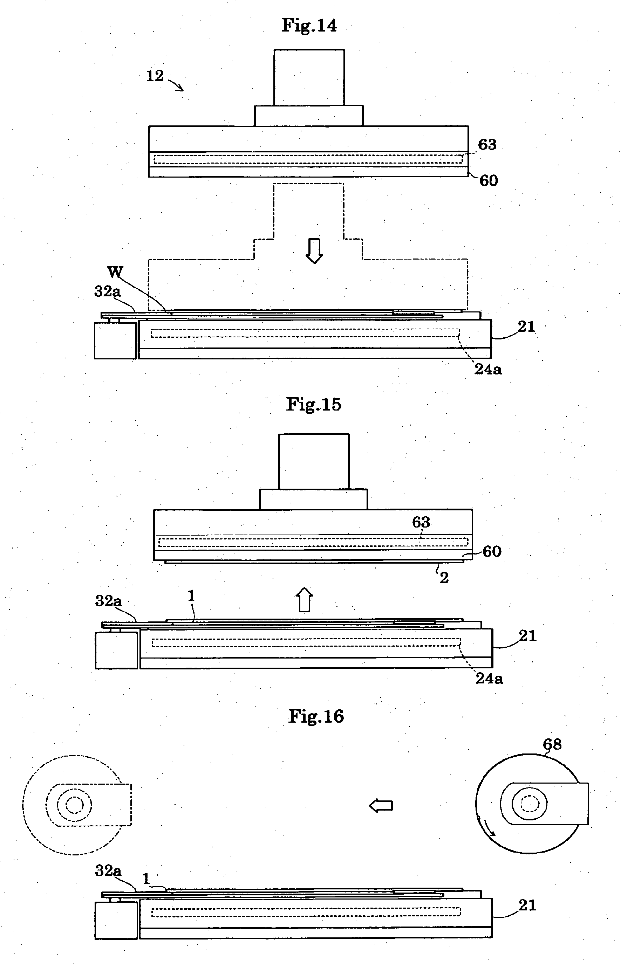

Subsequently, as illustrated in Figure 14, the suction plate 60 of the support-plate removing mechanism 12 moves downward until the plate contacts the upper surface of the workpiece W. Then the workpiece W is heated with the heater 63 embedded in the suction plate 60 in corporation with the heater 24a in the first table 21. Consequently, the adhesive layer 3b with heating separation properties on the double-faced adhesive tape 3 foams and expands due to heating with the suction plate 60 and the first table 21, resulting in loss of adhesion.

When heating for a given time is completed, the suction plate 60 moves upward while the support substrate 2 is suction-held, as illustrated in Figure 15. Here, the adhesive layer 3b having no adhesion is separated from the lower surface of the support plate 2. Accordingly, only the support plate moves upward.

The wafer 1 is held on the first table 21 from which the support plate is removed. Here, on the wafer 1, the double-faced adhesive tape 3 remains that expands to lose its adhesion and has the exposed adhesive layer 3b with the uneven surface. As illustrated in Figure 16, the separation roller 68 is moved from the standby position to the separation-starting position.

Here, the separation roller 68 stops at the separation starting end. Moreover, the separation roller 68 rotates to control the position of the suction holes 71 as to be directed downward for sucking the separation starting end of the double-faced adhesive tape 3.

Upon completion of control in position of the separation roller 68 in the separation starting position, the cylinder operates to move the first table 21 upward to appropriately press the double-faced adhesive tape 3 by the separation roller 68. Simultaneously, the separation roller 68 moves toward the separation termination end while sucking the double-faced adhesive tape 3, thereby winding up and separates the double-faced adhesive tape 3.

When the separation roller 68 moves across the separation termination end to the standby position, the suction device is switched to positive pressure. Accordingly, air blows out from the suction holes 71 for separating the double-faced adhesive tape 3 from the separation roller 68 and collecting the tape into the collection box in the tape collecting section 13.

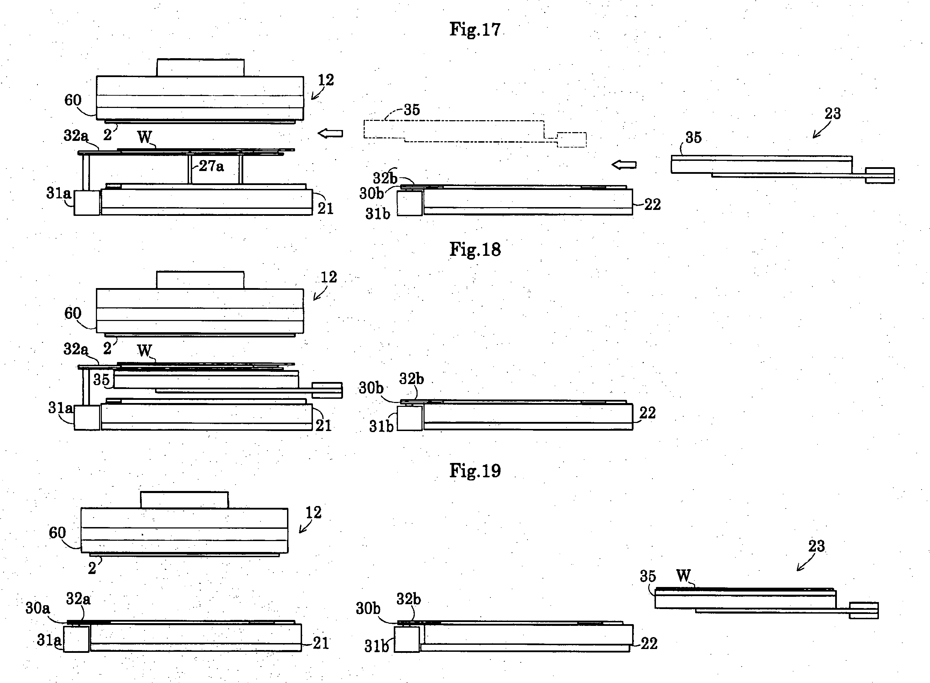

Subsequently, cylinders 28a and 31a of the lifting mechanism 29a operate. Accordingly, the pins 27a and the support claws 32 are moved upward at the same velocity to project from the first table 21, and push the wafer 1 away from the first table 21, as illustrated in Figure 17.

Then, as illustrated in Figure 18, the suction plate 35 of the wafer transporting mechanism 23 enters between the wafer 1 and the first table 21 from the opening of the lifting mechanism 29a. The pins 27a move downward synchronously with the suction plate 35 so as not to contact the plate. When the suction plate 35 reaches a holding position of the wafer 1, the plate 30a is moved downward to suction-hold the wafer 1 on the surface thereof.

Since the suction plate 35 is heated at a temperature lower than that of the first table 21, the wafer 1 is cooled into a target temperature during transporting the plate. At this time, the rear face of the wafer 1 is entirely suction-held with the suction plate 35 to be kept planar. Consequently, warp due to difference in expansion coefficient between the resin 1b and the bear chip 1b is eliminated. Moreover, deformation or running of the resin 1b is restricted by contact of the suction plate, and thus the wafer is kept planar. Then, as illustrated in Figure 19, the wafer transporting mechanism 23 moves into a given position while suction-holding the wafer 1 and then stops.

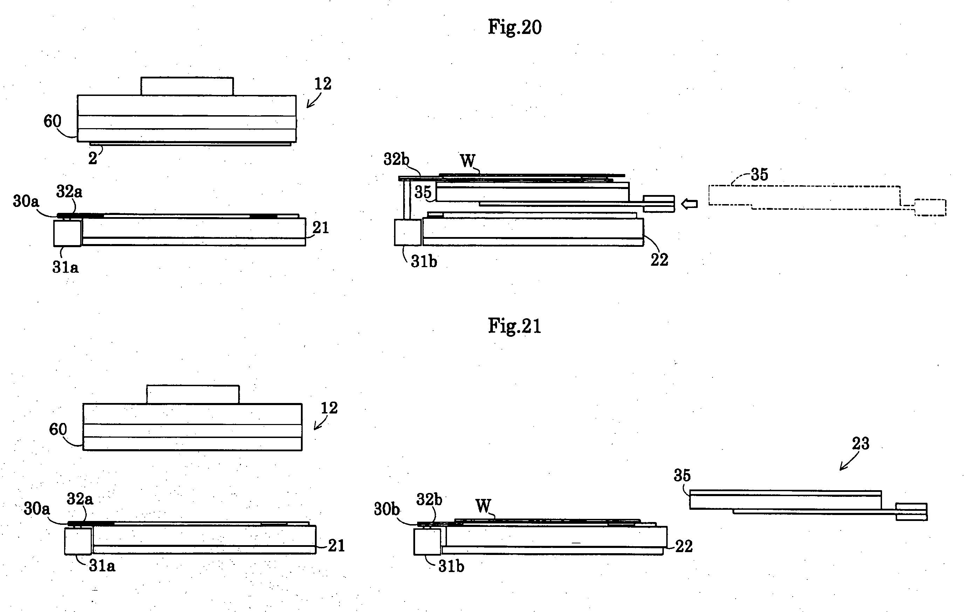

When the wafer 1 reaches the target temperature, the suction plate 35 is moved into a delivery position on the second table 22, as illustrated in Figure 20. The lifting mechanism 29b operates, and then the support claws 32b are moved upward through the notches of the suction plate 35 to support the wafer 1 at two or more portions on the outer periphery of the wafer. Then, the suction-holding of the suction plate 35 is released and the support claws 32b are further moved upward such that the wafer 1 is spaced away from the suction plate 35. Simultaneously, the suction plate 35 retracts from the delivery position.

Simultaneously, the pins 27b are moved upward beyond the second table 22 to support the center region of the wafer 1 at two or more portions of the wafer 1. Under this condition, the support claws 32b and the pins 27b are moved downward synchronously at the same velocity. As illustrated in Figure 21, the wafer 1 reaches the second table 22 and is suction-held on the rear face thereof. Then the wafer 1 is cooled down to be of room temperatures on the second table 22.

The temperature sensor 25b monitors temperatures of the wafer 1. When the temperature of the wafer 1 reaches room temperatures, the wafer 1 is unloaded from the second table 22. Firstly, suction-holding of the wafer 1 on the second table 22 is released, and the pins 27b are moved upward. Then, the wafer 1 is spaced away from the second table 22. Thereafter, the second robot arm 8 of the second substrate transporting mechanism 9 suction-holds the rear face of the wafer 1, and transports the wafer 1. Subsequently, the pins 27b are moved downward inside of the second table 22.

The wafer 1 unloaded by the second robot arm 8 is placed on a chuck table 75 in the marking section 15. The wafer 1 is then aligned on the chuck table 75 in accordance with notches. Thereafter, a given outer periphery portion of the wafer 1 is marked with laser.

Upon completion of the marking, the second robot arm 8 again suction-holds the wafer 1. Then, the second robot arm 8 places the wafer 1 onto a wafer delivery section 16. The wafer 1 is moved to a delivery position of a fourth robot arm 17 while the suction pad 77 suction-holds the rear face of the wafer 1.

Then, the fourth robot arm 17 suction-holds the rear face of the wafer 1, and houses the wafer into the cassette C2 with an exposed surface of the bear chip 1a directed upward.

While the wafer transporting mechanism 23 transports the wafer 1, the support plate 2 is collected into the cassette C1 via another path.

The support plate 2 removed by the support plate removing mechanism 12 and suction-held on the suction plate 60 is suction-held by the second robot arm 8 on the rear face thereof. The second robot arm 8 delivers the wafer 1 onto a suction pad of the cooling mechanism 7. The suction pad suction-holds the rear face of the support plate 2 and rotates the support plate 2. The cooling unit sprays air onto the surface of the support plate 2 in synchronism with rotation of the suction pad. When the support plate 2 reaches room temperatures as the target temperature, air stops being supplied and the suction pad stops rotating.

The first robot arm 5 suction-holds the surface of the support plate 2 to turn the support plate 2 upside down. Thereafter, the first robot arm 5 houses the wafer into a given empty space of the cassette C1.

As noted above, a round of operation is completed. The similar operation is to be repeated hereinafter.

The apparatus according to the example above enables the followings. That is, the suction plate 35 heated at a temperature lower than the heating temperature of the first table 21 allows contacting the entire surface of the resin 1b when the support plate 2 is removed with the first table 21 although the resin 1b of the wafer 1 is heated to be softened. The entire surface of the resin b is suction-held with the suction plate 35. Then the wafer 1 is cooled into a temperature at which no running of the resin or deformation of the wafer occurs due to its own weight of the resin 1b at the outer periphery of the wafer 1. Under this state, the wafer 1 is delivered to the second table 22.

As noted above, the wafer 1 is suction-held with the suction plate 35 so as to eliminate warp of the wafer or running of the resin 1b due to the softened resin 1b. Consequently, the wafer 1 is cooled until the hardness of the resin 1b exceeds its own weight of the wafer 1, and thus no deformation occurs in the resin 1b. As a result, the wafer 1 is transported under a planar state. Moreover, no running of the resin occurs on the outer periphery of the wafer 1. Thus the wafer 1 has a uniform thickness and enables to be held horizontally during the subsequent dicing process Consequently, the wafer 1 enables to be diced accurately along a desired scrub line.

Moreover, the support claws 32a and 32b support the wafer 1 at the outer periphery on the rear face of the wafer, and the pins 27a and 27b support the wafer 1 at two or more portions in the center region on the rear face of the wafer during loading and unloading the wafer 1 into and from the tables 21 and 22, respectively. As a result, although suction-holding of the wafer 1 with the tables 21 and 22 and with the suction plate 35 is released, the wafer 1 allows to be held almost horizontally. In other words, since the wafer 1 is held in a planar state, warp of the wafer 1 or protrusion of the resin can be avoided.

Moreover, when the wafer 1 has a diameter of 12cm or more, it becomes difficult to conventionally control a flow rate of air to float the wafer 1 and transport the wafer 1 accurately along a given path. Consequently, the wafer 1 contacts the side wall for drop prevention and thus is damaged.

On the other hand, the apparatus according to the example mentioned above enables the wafer 1 to be suction-held and transported with the suction plate 35 having a diameter larger than the wafer 1. Consequently, the wafer 1 is ensured to be transported on a given transportation path without contacting the edge thereof to other elements. That is, no damage occurs in the wafer 1 upon transportation the wafer 1.

This invention may be embodied as the following aspects.
(1) In the foregoing exemplary apparatus, the wafer 1 having an approximately circular shape is a target for treatment. This shape is not limitative. For instance, the wafer 1 may be a molded substrate having a quadranglar shape, such as a rectangular shape and a square shape. It is difficult to control transportation of the quadranglar substrate in a non-contact manner in comparison with the circular-shaped substrate. Consequently, the wafer may be damaged readily when the wafer contacts the wide wall for drop prevention. On the other hand, in the exemplary apparatus, the table and the suction plate 35 are changed in shape so as to accommodate the substrate. This allows overcoming the problem mentioned above. Alternatively, the first table 21, the second table 22, and the suction plate 35 of the wafer transporting mechanism 23 are formed into a quadranglar shape, and the plates 30a and 30b covering the first and the second tables are formed into a U-shape. Such configuration may be adopted.
(2) In the foregoing exemplary apparatus, the temperature sensor detects the temperature of the wafer 1 to determine timing for transportation. Alternatively, the following may be adopted. That is, time characteristics of dropping the temperature of the wafer 1 are determined in advance, and timing for transporting the wafer 1 is determined in accordance with time in response to the time characteristics.
(3) In the foregoing exemplary apparatus, the support-plate removing mechanism 12 leaves the double-faced adhesive tape 3 on a wafer 1 side. Alternatively, the double-faced adhesive tape 3 may remain on a support plate 2 side. Herein, an adhesive layer with a heating separation property may be joined on the wafer 1 side.
(4) The foregoing exemplary apparatus has been described using the suction plate 35 for vacuum-suction. This is not limitative. Alternatively, a configuration for suction-holding the entire rear face of the wafer 1 may be adopted. For instance, an electrostatic chuck-type plate can be adopted.
(5) The foregoing exemplary apparatus has been described taking as one example the first table 21 in which the resin is softened at the glass transition temperature or more. This is not limitative. That is, the wafer 1 that is readily softened due to heating at less than the glass transition temperature may be included. In this case, the wafer 1 also enables to be transported accurately with no warp of the wafer or running of the resin.

## Claims

1. A method of transporting a substrate, comprising:
suction-holding a substrate with a suction plate (35), **characterized in that**
the substrate is being formed by molding two or more chips (1a) arranged planarly with a resin (1b), and in suction-holding while cooling the heated substrate during transporting the substrate.

2. The method of transporting the substrate according to claim 1, wherein
in a process of transporting the substrate on two or more tables (21, 22) including a loading table and an unloading table with various set temperatures while suction-holding the substrate with the suction plate (35), a cooling temperature of the suction plate (35) is adjusted so as to fall between a set temperature of the loading table and that of the unloading table.

3. The method of transporting the substrate according to claim 1, wherein
in a process of transporting the heated substrate from the loading table while being suction-held with the suction plate (35), the substrate is cooled into a temperature at which the resin (16) does not deform or run due to its own weight, and
the substrate reaching the temperature is received on the unloading table, and then is cooled on the loading table into room temperatures.

4. An apparatus for transporting a substrate, comprising:
a transport mechanism (23) with a suction plate (35) for suction-holding a substrate;
two or more tables (21, 22) including a loading table and an unloading table,
the substrate has been formed by molding two or more chips (1a) arranged planarly with a resin (1b); **characterized in that**
the suction plate (35) is adapted for suction-holding while cooling the substrate; and in
a controller (80) for adjusting temperatures of the suction plate (35) and the tables (21, 22) such that a temperature of the substrate falls into a target temperature during transporting while suction-holding the substrate with the suction plate (35) onto each of the tables (21, 22) having various temperatures.

5. The apparatus for transporting the substrate according to claim 4, further comprising:
a detector for detecting a temperature of the substrate, wherein
the controller (80) is configured to adjust timing of unloading and loading the substrate from and to each of the tables (21, 22) in accordance with detection data from the detector.

6. The apparatus for transporting the substrate according to claim 4, further comprising:
a support plate (30a) having support claws (32a) for supporting the substrate at two or more portions on an outer periphery in a rear face of the substrate that is covered with the resin (1b); and
a drive mechanism for moving the substrate on the support claws (32a) onto a placing surface of the table and an unloading position above the table by moving the support plate (30a) upward and downward.

7. The apparatus for transporting the substrate according to claim 4, further comprising:
two or more support pins (27a) for supporting the substrate covered with the resin (1b) on a center region in a rear face of the substrate.

## Patentansprüche

1. Substrattransportverfahren, umfassend:
Saughalten eines Substrats mit einer Saugplatte (35), **dadurch gekennzeichnet, dass**
das Substrat durch Formen von zwei oder mehr Chips (1a) gebildet wird, die in einer Ebene mit einem Harz (1b) angeordnet sind, und sauggehalten wird,
während das erhitzte Substrat beim Transportieren des Substrats gekühlt wird.

2. Substrattransportverfahren nach Anspruch 1, wobei in einem Substrattransportvorgang auf zwei oder mehr Tischen (21, 22), einschließlich eines Beladetischs und eines Entladetischs mit verschiedenen geregelten Temperaturen während des Saughaltens des Substrats mit der Saugplatte (35), eine Kühltemperatur der Saugplatte (35) derart angepasst wird, dass sie zwischen einer eingestellten Temperatur des Beladetischs und der des Entladetischs liegt.

3. Substrattransportverfahren nach Anspruch 1, wobei in einem Transportvorgang des erhitzten Substrats von dem Beladetisch, während es mit der Saugplatte (35) sauggehalten wird, das Substrat auf eine Temperatur gekühlt wird, bei der das Harz (1b) sich nicht verformt oder aufgrund seines Eigengewichts läuft,
und
das Substrat beim Erreichen der Temperatur auf dem Entladetisch aufgenommen wird und dann auf dem Beladetisch auf Raumtemperaturen gekühlt wird.

4. Substrattransportvorrichtung, umfassend:
einen Transportmechanismus (23) mit einer Saugplatte (35) zum Saughalten eines Substrats;
zwei oder mehr Tische (21, 22) einschließlich eines Beladetischs und eines Entladetischs,
das Substrat ist durch Formen von zwei oder mehr Chips (1a) gebildet worden,
die in einer Ebene mit einem Harz (1b) angeordnet sind; **dadurch gekennzeichnet, dass**
die Saugplatte (35) zum Saughalten während des Kühlens des Substrats angepasst ist;
und durch
eine Steuerung (80) zum Anpassen von Temperaturen der Saugplatte (35) und der Tische (21, 22), sodass eine Substrattemperatur beim Transportieren unter Saughalten des Substrats mit der Saugplatte (35) auf jeden der Tische (21, 22), die verschiedene Temperaturen aufweisen, in eine Zieltemperatur fällt.

5. Substrattransportvorrichtung nach Anspruch 4, überdies umfassend:
einen Messfühler zum Erfassen einer Substrattemperatur, wobei die Steuerung (80) ausgestaltet ist, das Timing des Entladens und Beladens des Substrats von und auf jeden der Tische (21, 22) in Übereinstimmung mit den Erfassungsdaten des Messfühlers anzupassen.

6. Substrattransportvorrichtung nach Anspruch 4, überdies umfassend:
eine Stützplatte (30a) mit Stützklauen (32a) zum Stützen des Substrats in zwei oder mehr Abschnitten auf einem äußeren Umfang in einer Rückseite des Substrats, die mit dem Harz (1b) bedeckt ist; und
einen Antriebsmechanismus zum Bewegen des Substrats auf den Stützklauen (32a) auf eine Platzierungsfläche des Tischs und eine Entladeposition über dem Tisch durch Aufwärts- und Abwärtsbewegen der Stützplatte (30a).

7. Substrattransportvorrichtung nach Anspruch 4, überdies umfassend:
zwei oder mehr Stützstifte (27a) zum Stützen des mit dem Harz (1b) bedeckten Substrats in einem mittleren Bereich in einer Rückseite des Substrats.

## Revendications

1. Procédé de transport d'un substrat, comprenant :
la retenue par aspiration d'un substrat avec un plateau d'aspiration (35),
**caractérisé en ce que**
le substrat est formé par le moulage de deux tranches (1a) ou davantage agencées à plat avec une résine (1b), et en retenant par aspiration le substrat chauffé tout en le refroidissant pendant le transport du substrat.

2. Procédé de transport du substrat selon la revendication 1, dans lequel
dans un processus de transport du substrat sur deux tables (21, 22) ou davantage incluant une table de chargement et une table de déchargement avec différentes températures réglées tout en retenant par aspiration le substrat avec le plateau d'aspiration (35), une température de refroidissement du plateau d'aspiration (35) est ajustée de façon à se situer entre une température réglée de la table de chargement et celle de la table de déchargement.

3. Procédé de transport du substrat selon la revendication 1, dans lequel,
dans un processus de transport du substrat chauffé à partir de la table de chargement pendant qu'il est retenu par aspiration avec le plateau d'aspiration (35), le substrat est refroidi à une température à laquelle la résine (1b) ne se déforme pas ou ne coule pas sous l'action de son propre poids, et
le substrat atteignant la température est reçu sur la table de déchargement, et puis est refroidi sur la table de chargement aux températures ambiantes.

4. Appareil pour transporter un substrat, comprenant :
un mécanisme de transport (23) avec un plateau d'aspiration (35) pour retenir par aspiration un substrat ;
deux tables (21, 22) ou davantage incluant une table de chargement et une table de déchargement,
le substrat a été formé par le moulage de deux tranches (1a) ou davantage agencées à plat avec une résine (1b) ; **caractérisé en ce que**
le plateau d'aspiration (35) est adapté pour retenir le substrat par aspiration tout en le refroidissant ;
et par
un régulateur (80) pour ajuster des températures du plateau d'aspiration (35) et des tables (21, 22) de telle sorte qu'une température du substrat se situe à une température cible pendant le transport tout en retenant par aspiration le substrat avec le plateau d'aspiration (35) sur chacune des tables (21, 22) ayant diverses températures.

5. Appareil pour transporter le substrat selon la revendication 4, comprenant également :
un détecteur pour détecter une température du substrat, dans lequel le régulateur (80) est configuré pour ajuster le timing de déchargement et de chargement du substrat à partir de et vers chacune des tables (21, 22) en fonction de données de détection en provenance du détecteur.

6. Appareil pour transporter le substrat selon la revendication 4, comprenant également :
un plateau de support (30a) ayant des griffes de support (32a) pour supporter le substrat au niveau de deux portions ou davantage sur une périphérie extérieure dans une face arrière du substrat qui est recouverte par la résine (1b) ; et
un mécanisme d'entraînement pour déplacer le substrat sur les griffes de support (32a) en direction d'une surface de placement de la table et une position de déchargement au-dessus de la table en déplaçant le plateau de support (30a) vers le haut et vers le bas.

7. Appareil pour transporter le substrat selon la revendication 4, comprenant également :
deux broches de support (27a) ou davantage pour supporter le substrat recouvert par la résine (1b) sur une région centrale dans une face arrière du substrat.
